(19) Europäisches Patentamt / European Patent Office / Office européen des brevets

(11) **EP 3 101 706 A1**

(12) **EUROPEAN PATENT APPLICATION**

(43) Date of publication:
07.12.2016 Bulletin 2016/49

(51) Int Cl.:
*H01L 51/46* (2006.01)      *H01L 51/00* (2006.01)

(21) Application number: 16180086.7

(22) Date of filing: 11.10.2013

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(30) Priority: 11.10.2012   US 201261712783 P
22.10.2012   US 201261717073 P
18.02.2013   US 201361766098 P

(62) Document number(s) of the earlier application(s) in
accordance with Art. 76 EPC:
13852372.5 / 2 907 171

(71) Applicants:
• The Regents of The University of Michigan
Ann Arbor, MI 48109-2590 (US)
• Industry-Academic Cooperation Foundation
Dankook University
Gyeonggi-do 448-701 (KR)

(72) Inventors:
• FORREST, Stephen R.
Ann Arbor, MI 48104 (US)
• LEE, Jun Yeob
446-572 Yongin-si Gyeonggi-do (KR)
• CHO, Yong Joo
Seoul (KR)
• CHIN, Byung D
463-951 Seongnam-si Gyeonggi-do (KR)

(74) Representative: Finnegan Europe LLP
16 Old Bailey
London EC4M 7EG (GB)

Remarks:
This application was filed on 19-07-2016 as a
divisional application to the application mentioned
under INID code 62.

(54) **POLYMER PHOTOVOLTAICS EMPLOYING A SQUARAINE DONOR ADDITIVE**

(57)    Disclosed herein are organic photosensitive optoelectronic devices comprising two electrodes in superposed relation, a photoactive region located between the two electrodes, wherein the photoactive region comprises a donor mixture and an organic acceptor material, the donor mixture comprising at least one organic polymer donor material and at least one squaraine donor. Methods of fabricating the organic photosensitive optoelectronic devices are also disclosed.

*FIG. 2*

**EP 3 101 706 A1**

**Description**

<u>**Cross-Reference to Related Application**</u>

This application claims the benefit of U.S. Provisional Application No. 61/712,783, filed October 11, 2012, U.S. Provisional Application No. 61/717,073, filed October 22, 2012, and U.S. Provisional Application No. 61/766,098, filed February 18, 2013, all of which are incorporated herein by reference in their entirety.

<u>**Statement Reaarding Federally Sponsored Research**</u>

This invention was made with U.S. Government support under Contract No. FA9550-10-1-0339 awarded by the Air Force Office of Scientific Research. The government has certain rights in the invention.

<u>**Joint Research Agreement**</u>

The subject matter of the present disclosure was made by, on behalf of, and/or in connection with one or more of the following parties to a joint university-corporation research agreement: The Regents of the University of Michigan and Global Photonic Energy Corporation. The agreement was in effect on and before the date the subject matter of the present disclosure was prepared, and was made as a result of activities undertaken within the scope of the agreement.

The present disclosure generally relates to electrically active, optically active, solar, and semiconductor devices and, in particular, to organic photosensitive optoelectronic devices having a donor mixture comprising at least one organic polymer donor material and at least one squaraine donor. Methods of fabricating the organic photosensitive optoelectronic devices are also disclosed herein.

Optoelectronic devices rely on the optical and electronic properties of materials to either produce or detect electromagnetic radiation electronically or to generate electricity from ambient electromagnetic radiation.

Photosensitive optoelectronic devices convert electromagnetic radiation into electricity. Solar cells, also called photovoltaic (PV) devices, are a type of photosensitive optoelectronic device that is specifically used to generate electrical power. PV devices, which may generate electrical energy from light sources other than sunlight, can be used to drive power consuming loads to provide, for example, lighting, heating, or to power electronic circuitry or devices such as calculators, radios, computers or remote monitoring or communications equipment. These power generation applications also often involve the charging of batteries or other energy storage devices so that operation may continue when direct illumination from the sun or other light sources is not available, or to balance the power output of the PV device with a specific application's requirements. As used herein the term "resistive load" refers to any power consuming or storing circuit, device, equipment or system.

Another type of photosensitive optoelectronic device is a photoconductor cell. In this function, signal detection circuitry monitors the resistance of the device to detect changes due to the absorption of light.

Another type of photosensitive optoelectronic device is a photodetector. In operation, a photodetector is used in conjunction with a current detecting circuit which measures the current generated when the photodetector is exposed to electromagnetic radiation and may have an applied bias voltage. A detecting circuit as described herein is capable of providing a bias voltage to a photodetector and measuring the electronic response of the photodetector to electromagnetic radiation.

These three classes of photosensitive optoelectronic devices may be characterized according to whether a rectifying junction as defined below is present and also according to whether the device is operated with an external applied voltage, also known as a bias or bias voltage. A photoconductor cell does not have a rectifying junction and is normally operated with a bias. A PV device has at least one rectifying junction and is operated with no bias. A photodetector has at least one rectifying junction and is usually but not always operated with a bias. As a general rule, a photovoltaic cell provides power to a circuit, device or equipment, but does not provide a signal or current to control detection circuitry, or the output of information from the detection circuitry. In contrast, a photodetector or photoconductor provides a signal or current to control detection circuitry, or the output of information from the detection circuitry but does not provide power to the circuitry, device or equipment.

Traditionally, photosensitive optoelectronic devices have been constructed of a number of inorganic semiconductors, *e.g.*, crystalline, polycrystalline and amorphous silicon, gallium arsenide, cadmium telluride and others. Herein the term "semiconductor" denotes materials which can conduct electricity when charge carriers are induced by thermal or electromagnetic excitation. The term "photoconductive" generally relates to the process in which electromagnetic radiant energy is absorbed and thereby converted to excitation energy of electric charge carriers so that the carriers can conduct, *i.e.*, transport, electric charge in a material. The terms "photoconductor" and "photoconductive material" are used herein to refer to semiconductor materials which are chosen for their property of absorbing electromagnetic radiation to generate electric charge carriers.

PV devices may be characterized by the efficiency with which they can convert incident solar power to useful electric power. Devices utilizing crystalline or amorphous silicon dominate commercial applications, and some have achieved efficiencies of 23% or greater. However, efficient crystalline-based devices, especially of large surface area, are difficult and expensive to produce due to the problems inherent in producing large crystals without significant efficiency-degrading defects. On the other hand, high efficiency amorphous silicon devices still suffer from problems with stability. Present commercially available amorphous silicon cells have stabilized efficiencies between 4 and 8%. More recent efforts have focused on the use of organic photovoltaic cells to achieve acceptable photovoltaic conversion efficiencies with economical production costs.

PV devices may be optimized for maximum electrical power generation under standard illumination conditions (i.e., Standard Test Conditions which are 1000 W/$m^2$, AM1.5 spectral illumination), for the maximum product of photocurrent times photovoltage. The power conversion efficiency of such a cell under standard illumination conditions depends on the following three parameters:

(1) the current under zero bias, i.e., the short-circuit current $I_{SC}$, in Amperes (2) the photovoltage under open circuit conditions, i.e., the open circuit voltage $V_{OC}$, in Volts and (3) the fill factor, *FF*.

PV devices produce a photo-generated current when they are connected across a load and are irradiated by light. When irradiated under infinite load, a PV device generates its maximum possible voltage, V open-circuit, or $V_{OC}$. When irradiated with its electrical contacts shorted, a PV device generates its maximum possible current, I short-circuit, or $I_{SC}$. When actually used to generate power, a PV device is connected to a finite resistive load and the power output is given by the product of the current and voltage, $I \times V$. The maximum total power generated by a PV device is inherently incapable of exceeding the product, $I_{SC} \times V_{OC}$. When the load value is optimized for maximum power extraction, the current and voltage have the values, $I_{max}$ and $V_{max}$, respectively.

A figure of merit for PV devices is the fill factor, FF, defined as:

$$FF = \{\ I_{max}\ V_{max}\ \}/\{\ I_{SC}\ V_{OC}\ \} \qquad\qquad (1)$$

where *FF* is always less than 1, as $I_{SC}$ and $V_{OC}$ are never obtained simultaneously in actual use. Nonetheless, as *FF* approaches 1, the device has less series or internal resistance and thus delivers a greater percentage of the product of $I_{SC}$ and $V_{OC}$ to the load under optimal conditions. Where $P_{inc}$ is the power incident on a device, the power efficiency of the device, $\eta_P$, may be calculated by:

$$\eta_P = FF^* \ (I_{SC} \ ^* \ V_{OC}) \ / \ P_{inc}$$

To produce internally generated electric fields that occupy a substantial volume of the semiconductor, the usual method is to juxtapose two layers of material (donor and acceptor) with appropriately selected conductive properties, especially with respect to their distribution of molecular quantum energy states. The interface of these two materials is called a photovoltaic junction. In traditional semiconductor theory, materials for forming PV junctions have been denoted as generally being of either n or p type. Here n-type denotes that the majority carrier type is the electron. This could be viewed as the material having many electrons in relatively free energy states. The p-type denotes that the majority carrier type is the hole. Such material has many holes in relatively free energy states. The type of the background, i.e., not photo-generated, majority carrier concentration depends primarily on unintentional doping by defects or impurities. The type and concentration of impurities determine the value of the Fermi energy, or level, within the gap between the conduction band minimum and valance band maximum energies, also known as the HOMO-LUMO gap. The Fermi energy characterizes the statistical occupation of molecular quantum energy states denoted by the value of energy for which the probability of occupation is equal to ½. A Fermi energy near the conduction band minimum (LUMO) energy indicates that electrons are the predominant carrier. A Fermi energy near the valence band maximum (HOMO) energy indicates that holes are the predominant carrier. Accordingly, the Fermi energy is a primary characterizing property of traditional semiconductors and the prototypical PV junction has traditionally been the p-n interface.

The term "rectifying" denotes, *inter alia,* that an interface has an asymmetric conduction characteristic, i.e., the interface supports electronic charge transport preferably in one direction. Rectification is associated normally with a built-in electric field which occurs at the junction between appropriately selected materials.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

A significant property in organic semiconductors is carrier mobility. Mobility measures the ease with which a charge carrier can move through a conducting material in response to an electric field. In the context of organic photosensitive devices, a layer including a material that conducts preferentially by electrons due to a high electron mobility may be referred to as an electron transport layer, or ETL. A layer including a material that conducts preferentially by holes due to a high hole mobility may be referred to as a hole transport layer, or HTL. In some cases, an acceptor material may be an ETL and a donor material may be an HTL.

Conventional inorganic semiconductor PV cells may employ a p-n junction to establish an internal field. However, it is now recognized that in addition to the establishment of a p-n type junction, the energy level offset of the heterojunction may also play an important role.

The energy level offset at an organic donor-acceptor (D-A) heterojunction is believed to be important to the operation of organic PV devices due to the fundamental nature of the photogeneration process in organic materials. Upon optical excitation of an organic material, localized Frenkel or charge-transfer excitons are generated. For electrical detection or current generation to occur, the bound excitons must be dissociated into their constituent electrons and holes. Such a process can be induced by the built-in electric field, but the efficiency at the electric fields typically found in organic devices (F ~ $10^6$ V/cm) is low. The most efficient exciton dissociation in organic materials occurs at a D-A interface. At such an interface, the donor material with a low ionization potential forms a heterojunction with an acceptor material with a high electron affinity. Depending on the alignment of the energy levels of the donor and acceptor materials, the dissociation of the exciton can become energetically favorable at such an interface, leading to a free electron polaron in the acceptor material and a free hole polaron in the donor material.

Carrier generation requires exciton generation, diffusion, and ionization or collection. There is an efficiency η associated with each of these processes. Subscripts may be used as follows: P for power efficiency, EXT for external quantum efficiency, A for photon absorption, ED for diffusion, CC for collection, and INT for internal quantum efficiency. Using this notation:

$$\eta_P \sim \eta_{EXT} = \eta_A * \eta_{ED} * \eta_{CC}$$

$$\eta_{EXT} = \eta_A * \eta_{INT}$$

The diffusion length ($L_D$) of an exciton is typically much less ($L_D \sim$ 50 A) than the optical absorption length (~500 Å), requiring a tradeoff between using a thick, and therefore resistive, cell with multiple or highly folded interfaces, or a thin cell with a low optical absorption efficiency.

Organic PV cells have many potential advantages when compared to traditional silicon-based devices. Organic PV cells are light weight, economical in materials use, and can be deposited on low cost substrates, such as flexible plastic foils. The reported efficiencies of some of the best organic PVs are around 10%. For commercialization, however, device efficiencies must further improve via new material and device design approaches.

One effective means for enhancing the power conversion efficiency (PCE) of organic PVs is to extend the device sensitivity into the near infrared (NIR) spectral region. This can be achieved by employing donor and/or acceptor materials with strong absorption at long wavelengths, or using a tandem structure with two or more stacked subcells, of which each has light absorption centered in a different spectral region. Although many polymers useful in organic PV devices have been developed, design and synthesis of molecules with significant NIR absorption can be both difficult and time-consuming. Furthermore, tandem design and fabrication can be complicated due to the large number of layers and parameters that must be optimized. Indeed, the stacking of two or more polymer organic PV subcells using solution processing, where solvents used to deposit one layer may dissolve previously deposited subcells, presents formidable challenges to fabrication.

It has been reported that blending two polymer donors can enhance the wavelength range for absorption, resulting in an increased short circuit current density ($J_{SC}$) and PCE. Small molecule additives for polymer donors have also been reported to increase the absorption wavelength range of organic PV cells.

Disclosed herein are organic photosensitive optoelectronic devices having a donor mixture comprising at least one organic polymer donor material and at least one squaraine donor. The donor mixture may expand the absorption range of the device and can improve $J_{SC}$ and PCE.

In one embodiment, an organic photosensitive optoelectronic device comprises two electrodes in superposed relation, a photoactive region located between the two electrodes, wherein the photoactive region comprises a donor mixture and an organic acceptor material, the donor mixture comprising at least one organic polymer donor material and at least one squaraine donor.

In some embodiments, the at least one squaraine donor has a maximum absorptivity at one or more wavelengths, the maximum absorptivity of the at least one squaraine donor being at least twice as large as an absorptivity of the at least one organic polymer donor material at the one or more wavelengths.

In some embodiments, the at least one squaraine donor has a maximum absorptivity at a longer wavelength than a maximum absorptivity of the at least one organic polymer donor material.

In some embodiments, the at least one squaraine donor has an absorptivity of at least $10^3$ cm$^{-1}$ at one or more wavelengths ranging from 450 to 950 nm. In some embodiments, the at least one squaraine donor has an absorptivity of at least $10^5$ cm$^{-1}$ at one or more wavelengths ranging from 450 to 950 nm.

In some embodiments, the donor mixture comprises the at least one organic polymer donor material and the at least one squaraine donor at a polymer donor: squaraine ratio ranging from 1: 0.005 to 1:0.2 by weight. In some embodiments, the polymer donor: squaraine ratio ranges from 1:0.01 to 1:0.1 by weight.

In some embodiments, the donor mixture and the organic acceptor material form a donor-acceptor heterojunction. In some embodiments, the donor-acceptor heterojunction is chosen from a mixed heterojunction, a bulk heterojunction, a planar heterojunction, and a hybrid planar-mixed heterojunction.

In some embodiments, the at least one squaraine donor is chosen from 2,4-bis[4-(N,N-diisobutylamino)-2,6-dihydroxyphenyl] (DBSQ), 2,4-bis[4-N-carbazolo-2,6-dihydroxyphenyl] squaraine (CBZSQ), 2,4-bis[4-N-phenothiazino-2,6-dihydroxyphenyl] squaraine (PTSQ), 2,4-bis[4-(N,N-diphenylamino)-2,6-dihydroxyphenyl] squaraine (DPSQ), 2,4-bis[4-(N-Phenyl-1-naphthylamino)-2,6-dihydroxyphenyl] squaraine (1 NPSQ), 2,4-bis[4-(N-Phenyl-2-naphthylamino)-2,6-dihydroxyphenyl] squaraine (2NPSQ), {2-[4-(N,N-diisobutylamino)-2,6-dihydroxyphenyl]-4-diphenylamino} squaraine (USSQ), {2-[4-(N,N-diphenylamino)-2,6-dihydroxyphenyl]-4-diphenylamino} squaraine (DPUSQ), and diphenylamino-squarate (YSQ).

In some embodiments, the at least one organic polymer donor material is chosen from polythiophene, polycarbazole, polyfluorene, polydithienosilole, polybenzodithiophene, and copolymers thereof.

In some embodiments, the at least one organic polymer donor material is chosen from poly[2-methoxy-5-(2'-ethylhexyloxy)-p-phenylene vinylene], poly(3-hexylthiophene) (P3HT), poly[2,6-(4,4-bis-(2-ethylhexyl)-4H-cyclopenta[2,1-b;3,4-b']dithiophene-alt-4,7-(2,1,3-benzothiadiazole)], poly[N-9"-hepta-decanyl-2,7-carbazole-alt-5,5-(4',7'-di-2-thienyl-2',1',3'-benzothiadiazole)], poly(4,4-dioctyldithieno(3,2-b:2',3'-d)silole)-2,6-diyl-alt-(2,1,3-benzothiadiazole)-4,7-diyl), poly{2,6-4,8-di(5-ethylhexylthienyl)benzo[1,2-b;3,4-b]dithiophene-alt-5-dibutyloctyl-3,6-bis(5-bromothiophen-2-yl)pyrrolo[3,4-c]pyrrole-1,4-dione}, poly[2,7-(9,9-didecylfluorene)-alt-5,5-(4,7-di-2-thienyl-2,1,3-benzothiadiazole)], and alternating copolymer of thieno[3,4-b]-thiophene and benzodithiophene.

In some embodiments, the organic acceptor material comprises at least one compound chosen from perylenes, naphthalenes, fullerenes, and derivatives thereof.

In certain embodiments, the at least one organic polymer donor material is P3HT and the organic acceptor material comprises a fullerene or a derivative thereof.

Also disclosed herein is a method of fabricating an organic photosensitive optoelectronic device comprising depositing a photoactive region over a first electrode, and depositing a second electrode over the photoactive region, wherein the photoactive region comprises a donor mixture and an organic acceptor material, the donor mixture comprising at least one organic polymer donor material and at least one squaraine donor.

In some embodiments, the deposition of a photoactive region over a first electrode comprises co-depositing the at least one organic polymer donor material and the at least one squaraine donor over the first electrode, and depositing the organic acceptor material over the first electrode, wherein the co-deposition of the at least one organic polymer donor material and the at least one squaraine donor occurs before or after the deposition of the organic acceptor material over the first electrode. In some embodiments, the at least one organic polymer donor material and the at least one squaraine donor are co-deposited at a ratio ranging from 1:0.005 to 1:0.2 by weight.

In other embodiments, the deposition of a photoactive region over a first electrode comprises co-depositing the at least one organic polymer donor material, the at least one squaraine donor, and the organic acceptor material over the first electrode. In some embodiments, the at least one organic polymer donor material, the organic acceptor material, and the at least one squaraine donor are co-deposited at a polymer donor: acceptor: squaraine ratio ranging from 1:0.5:x to 1:1.5:x by weight, wherein x represents a number ranging from 0.005 to 0.2.

The accompanying figures are incorporated in, and constitute a part of this specification.

**Figure 1** shows a schematic of an organic photosensitive optoelectronic device in accordance with the present disclosure.

**Figure 2** shows an example of a device schematic wherein the donor mixture is in contact with the acceptor material, forming a donor-acceptor heterojunction.

**Figure 3A** shows ultraviolet-visible absorption spectra of P3HT:PCBM:DBSQ films at varying concentrations of DBSQ; and **3B** shows x-ray diffraction spectra of P3HT:PCBM:DBSQ films at varying concentrations of DBSQ.

**Figure 4** shows atomic force microscopy images of (**A**) P3HT:PCBM film; (**B**) P3HT:PCBM:5 wt% DBSQ film; and (**C**) P3HT:PCBM:10 wt% DBSQ film. All films were annealed at 120 °C for 10 minutes. The scan area was 5 $\mu$m x 5 $\mu$m.

**Figure 5** shows plots of (**A**) current density vs. voltage; (**B**) power conversion efficiency vs. intensity; and (**C**) external quantum efficiency vs. wavelength for P3HT:PCBM:DBSQ photovoltaic cells at varying concentrations of DBSQ.

**Figure 6A** shows photoluminescence spectra of P3HT, P3HT:PCBM, P3HT:PCBM:5 wt% DBSQ and P3HT:PCBM:10 wt% DBSQ films; and **6B** shows a plot of the expansion of the low intensity region between wavelength of 600 and 800 nm.

As used herein, the term "co-depositing" or "co-deposition" may include simultaneously depositing materials independently (from separate sources) onto a substrate, where the ratio of the materials can be controlled by the rate of deposition of each material. In some cases, materials that are "co-deposited" may be deposited sequentially and subjected to further processing, such as thermal annealing or solvent annealing, to form a mixture. Vapor deposition methods are examples of these approaches. Alternatively, "co-depositing" or "co-deposition" may include mixing the materials at a desired ratio and depositing the mixed materials onto a substrate. Fluid solution deposition methods are examples of this alternative approach.

The terms "electrode" and "contact" are used herein to refer to a layer that provides a medium for delivering photo-generated current to an external circuit or providing a bias current or voltage to the device. That is, an electrode, or contact, provides the interface between the active regions of an organic photosensitive optoelectronic device and a wire, lead, trace or other means for transporting the charge carriers to or from the external circuit. Anodes and cathodes are examples. U.S. Patent No. 6,352,777, incorporated herein by reference for its disclosure of electrodes, provides examples of electrodes, or contacts, which may be used in a photosensitive optoelectronic device. In a photosensitive optoelectronic device, it may be desirable to allow the maximum amount of ambient electromagnetic radiation from the device exterior to be admitted to the photoconductive active interior region. That is, the electromagnetic radiation must reach a photoconductive layer(s), where it can be converted to electricity by photoconductive absorption. This often dictates that at least one of the electrical contacts should be minimally absorbing and minimally reflecting of the incident electromagnetic radiation. In some cases, such a contact should be transparent or at least semi-transparent. An electrode is said to be "transparent" when it permits at least 50% of the ambient electromagnetic radiation in relevant wavelengths to be transmitted through it. An electrode is said to be "semi-transparent" when it permits some, but less that 50% transmission of ambient electromagnetic radiation in relevant wavelengths. The opposing electrode may be a reflective material so that light which has passed through the cell without being absorbed is reflected back through the cell.

As used and depicted herein, a "layer" refers to a member or component of a photosensitive device whose primary dimension is X-Y, *i.e.*, along its length and width. It should be understood that the term layer is not necessarily limited to single layers or sheets of materials. In addition, it should be understood that the surfaces of certain layers, including the interface(s) of such layers with other material(s) or layers(s), may be imperfect, wherein said surfaces represent an interpenetrating, entangled or convoluted network with other material(s) or layer(s). Similarly, it should also be understood that a layer may be discontinuous, such that the continuity of said layer along the X-Y dimension may be disturbed or otherwise interrupted by other layer(s) or material(s).

As used herein, the expression that a material or component is deposited "over" another material or component permits other materials or layers to exist between the material or component being deposited and the material or component "over" which it is deposited. For example, a layer may be described as being deposited "over" an electrode, even though there are various materials or layers in between the layer and the electrode.

As used herein, the term "absorptivity" refers to the percentage of incident light at a given wavelength that is absorbed.

In the context of the organic materials of the present disclosure, the terms "donor" and "acceptor" refer to the relative positions of the HOMO and LUMO energy levels of two contacting but different organic materials. If the LUMO energy level of one material in contact with another is lower, then that material is an acceptor. Otherwise it is a donor. It is energetically favorable, in the absence of an external bias, for electrons at a donor-acceptor junction to move into the acceptor material, and for holes to move into the donor material.

The organic photosensitive optoelectronic devices of the present disclosure utilize a mixture of donor materials: at least one organic polymer material and at least one small molecule additive, wherein the small molecule additive is a squaraine donor. The donor mixture of at least one organic polymer material and a squaraine can expand the absorption range of an organic photosensitive optoelectronic device, leading to efficient light absorption, for example, from the visible spectrum into the NIR. The increased absorption efficiency can significantly increase the $J_{SC}$ and PCE of the device.

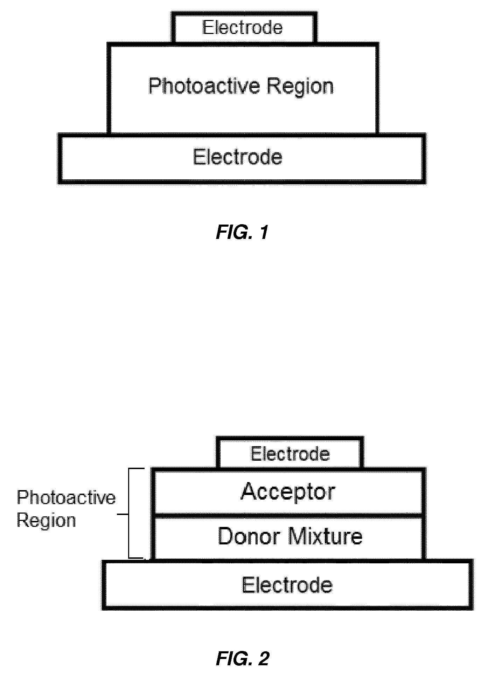

As shown in Fig. 1, an organic photosensitive device of the present disclosure comprises two electrodes in superposed relation, and a photoactive region located between the two electrodes. As used herein, the "photoactive region" refers to a region of the device that absorbs electromagnetic radiation to generate excitons. The excitons may dissociate into an electron and a hole in order to generate an electrical current. The photoactive region comprises a donor mixture and an organic acceptor material, wherein the donor mixture comprises at least one organic polymer donor material and at least one squaraine donor.

Absorption bands of the at least one squaraine donor and the at least one organic polymer donor material may complement one another to expand the light absorption wavelength range of the photosensitive device. In some embodiments, the at least one squaraine donor has a maximum absorptivity at one or more wavelengths, the maximum absorptivity of the at least one squaraine donor being at least twice as large as an absorptivity of the at least one organic polymer donor material at the one or more wavelengths. In some embodiments, the at least one squaraine donor has a maximum absorptivity at a longer wavelength than a maximum absorptivity of the polymer donor material. In some embodiments, the at least one squaraine donor has an absorptivity of at least $10^3$ cm$^{-1}$ at one or more wavelengths ranging from 450 to 950 nm, 450 to 800 nm, 500 to 750 nm, 650 to 950 nm, 650 to 900 nm or 700 to 850 nm. In some embodiments, the at least one squaraine donor has an absorptivity of at least $10^5$ cm$^{-1}$ at one or more wavelengths ranging from 450 to 950 nm, 450 to 800 nm, 500 to 750 nm, 650 to 950 nm, 650 to 900 nm or 700 to 850 nm.

The donor mixture and the organic acceptor material may form a donor-acceptor heterojunction. The donor-acceptor heterojunction may be any heterojunction known in the art for organic photosensitive devices. For example, in some embodiments, the donor-acceptor heterojunction may be chosen from a mixed heterojunction, a bulk heterojunction, a planar heterojunction, and a hybrid planar-mixed heterojunction. Fig. 2 shows an example of a device schematic wherein the donor mixture is in contact with the organic acceptor material, forming a donor-acceptor heterojunction. Although Fig. 2 depicts the donor mixture and the organic acceptor material as neat layers, it should be understood that the surfaces of the layers, such as the interface between the donor mixture and the organic acceptor material, may be imperfect, wherein said surfaces represent an interpenetrating, entangled or convoluted network with other material(s) or layer(s). In some embodiments, the photoactive region comprises a blend of the donor mixture and the organic acceptor material. As one of ordinary skill in the art would appreciate, the location of the donor mixture relative to the organic acceptor material depends on the desired type of donor-acceptor heterojunction for the device.

The amount of the at least one squaraine donor in the photoactive region may be optimized to achieve peak device performance. The optimization may include balancing increased absorption efficiency at increasing squaraine concentrations with series resistance effects at such increased concentrations. In some embodiments, the donor mixture comprises the at least one polymer donor material and the at least one squaraine donor at a polymer donor: squaraine ratio ranging from 1:0.005 to 1:0.2 by weight. In some embodiments, the polymer donor: squaraine ratio ranges from 1:0.01 to 1:0.1 by weight. In certain embodiments, the polymer donor: squaraine ratio is 1:0.05 by weight.

In some embodiments, the at least one organic polymer donor material, the acceptor material, and the at least one squaraine donor are present in the photoactive region at a polymer donor: acceptor: squaraine ratio ranging from 1:0.5:x to 1:1.5:x by weight, where x represents a number ranging from 0.005 to 0.2. In some embodiments, x represents a number ranging from 0.01 to 0.1.

The at least one organic polymer donor material may be any organic polymer donor material known in the art. Non-limiting mention is made to organic polymer donor materials chosen from polythiophene, polycarbazole, polyfluorene, polydithienosilole, polybenzodithiophene, and copolymers thereof. In some embodiments, the at least one organic polymer donor material may be chosen from poly[2-methoxy-5-(2'-ethylhexyloxy)-p-phenylene vinylene], poly(3-hexylthiophene) (P3HT), poly[2,6-(4,4-bis-(2-ethylhexyl)-4H-cyclopenta[2,1-b;3,4-b']dithiophene-alt-4,7-(2,1,3-benzothiadiazole)], poly[N-9"-hepta-decanyl-2,7-carbazole-alt-5,5-(4',7'-di-2-thienyl-2',1',3'-benzothiadiazole)], poly(4,4-dioctyldithieno(3,2-b:2',3'-d)silole)-2,6-diyl-alt-(2,1,3-benzothiadiazole)-4,7-diyl), poly{2,6-4,8-di(5-ethylhexylthienyl)benzo[1,2-b;3,4-b]dithiophene-alt-5-dibutyloctyl-3,6-bis(5-bromothiophen-2-yl)pyrrolo[3,4-c]pyrrole-1,4-dione}, poly[2,7-(9,9-didecylfluorene)-alt-5,5-(4,7-di-2-thienyl-2,1,3-benzothiadiazole)], and alternating copolymer of thieno[3,4-b]-thiophene and benzodithiophene.

The at least one squaraine donor may be any squaraine known in the art. In some embodiments, the at least one squaraine donor is chosen from from 2,4-bis[4-(N,N-diisobutylamino)-2,6-dihydroxyphenyl] squaraine (DBSQ), 2,4-bis[4-N-carbazolo-2,6-dihydroxyphenyl] squaraine (CBZSQ), 2,4-bis[4-N-phenothiazino-2,6-dihydroxyphenyl] squaraine (PTSQ), 2,4-bis[4-(N,N-diphenylamino)-2,6-dihydroxyphenyl] squaraine (DPSQ), 2,4-bis[4-(N-Phenyl-1-naphthylamino)-2,6-dihydroxyphenyl] squaraine (1 NPSQ), 2,4-bis[4-(N-Phenyl-2-naphthylamino)-2,6-dihydroxyphenyl] squaraine (2NPSQ), {2-[4-(N,N-diisobutylamino)-2,6-dihydroxyphenyl]-4-diphenylamino} squaraine (USSQ), {2-[4-(N,N-diphenylamino)-2,6-dihydroxyphenyl]-4-diphenylamino} squaraine (DPUSQ), and diphenylamino-squarate (YSQ). Additional examples of suitable squaraine donors are disclosed in U.S. Patent Publication No. 2012/0248419, which is incorporated herein by reference for its disclosure of squaraines.

Examples of the organic acceptor material include perylenes, naphthalenes, fullerenes, and derivatives thereof. Non-limiting mention is made to those chosen from $C_{60}$, $C_{70}$, $C_{76}$, $C_{82}$, $C_{84}$, 3,4,9,10-perylenetetracarboxylicbis-benzimidazole (PTCBI), Phenyl-$C_{61}$-Butyric-Acid-Methyl Ester ([60]PCBM), Phenyl-$C_{71}$-Butyric-Acid-Methyl Ester ([70]PCBM), Thienyl-$C_{61}$-Butyric-Acid-Methyl Ester ([60]ThCBM), and hexadecafluorophthalocyanine ($F_{16}$CuPc). In certain embodiments, the acceptor material is chosen from fullerenes and derivatives thereof. The organic acceptor material is not limited to a single material. A combination of acceptors can be used.

In some embodiments of the present disclosure, the at least one squaraine donor comprises two or more squaraine donors. The squaraine donors may be selected to complement the absorption of the at least one organic polymer donor material, as disclosed herein, to expand the light absorption wavelength range of the photosensitive device. In some embodiments, the two or more squaraine donors comprise at least a first squaraine donor and a second squaraine donor, wherein the absorption ranges of the first and second squaraine donors may fully or at least partially overlap. In some embodiments, the first squaraine donor has a maximum absorptivity at one or more wavelengths, the maximum absorptivity of the first squaraine donor being at least twice as large as an absorptivity of the second squaraine donor and an absorptivity of the at least one organic polymer donor at the one or more wavelengths. In some embodiments, the second squaraine donor has a maximum absorptivity at one or more wavelengths, the maximum absorptivity of the second squaraine donor being at least twice as large as an absorptivity of the first squaraine donor and an absorptivity of the at least one organic polymer donor at the one or more wavelengths.

One of the electrodes of the present disclosure may be an anode, and the other electrode a cathode. It should be understood that the electrodes should be optimized to receive and transport the desired carrier (holes or electrons). The term "cathode" is used herein such that in a non-stacked PV device or a single unit of a stacked PV device under ambient irradiation and connected with a resistive load and with no externally applied voltage, *e.g.*, a PV device, electrons move to the cathode from the photo-conducting material. Similarly, the term "anode" is used herein such that in a PV device under illumination, holes move to the anode from the photoconducting material, which is equivalent to electrons moving in the opposite manner.

The organic photosensitive optoelectronic devices of the present disclosure may have a conventional or inverted structure. Examples of inverted device structures are disclosed in U.S. Patent Publication No. 2010/0102304, which is incorporated herein by reference for its disclosure of inverted device structures.

The organic photosensitive optoelectronic devices of the present disclosure may further comprise additional layers as known in the art for such devices. For example, devices may further comprise charge carrier transport layers and/or buffers layers such as one or more blocking layers, such as an exciton blocking layer (EBL). One or more blocking layers may be located between the photoactive region and either or both of the electrodes. With regard to materials that may be used as an exciton blocking layer, non-limiting mention is made to those chosen from bathocuproine (BCP), bathophenanthroline (BPhen), 1,4,5,8-Naphthalene-tetracarboxylic-dianhydride (NTCDA), 3,4,9,10-perylenetetracarboxylicbis-benzimidazole (PTCBI), 1,3,5-tris(N-phenylbenzimidazol-2-yl)benzene (TPBi), tris(acetylacetonato) ruthenium(III) (Ru(acac)$_3$), and aluminum(III)phenolate (Alq$_2$ OPH), N,N'-diphenyl-N,N'-bis-alpha-naphthylbenzidine (NPD), aluminum tris(8-hydroxyquinoline) (Alq$_3$), and carbazole biphenyl (CBP).. Examples of blocking layers are described in U.S. Patent Publication Nos. 2012/0235125 and 2011/0012091 and in U.S. Patent Nos. 7,230,269 and 6,451,415, which are incorporated herein by reference for their disclosure of blocking layers.

The organic photosensitive optoelectronic devices of the present disclosure may comprise additional buffer layers as known in the art for such devices. For example, the devices may further comprise at least one smoothing layer. A smoothing layer may be located, for example, between the photoactive region and either or both of the electrodes. A film comprising 3,4-polyethylenedioxythiophene:polystyrenesulfonate (PEDOT:PSS) is an example of a smoothing layer.

The organic optoelectronic devices of the present disclosure may exist as a tandem device comprising two or more subcells. A subcell, as used herein, means a component of the device which comprises at least one photoactive region having a donor-acceptor heterojunction. When a subcell is used individually as a photosensitive optoelectronic device, it typically includes a complete set of electrodes. A tandem device may comprise charge transfer material, electrodes, or charge recombination material or a tunnel junction between the tandem donor-acceptor heterojunctions. In some tandem configurations, it is possible for adjacent subcells to utilize common, i.e., shared, electrode, charge transfer region or charge recombination zone. In other cases, adjacent subcells do not share common electrodes or charge transfer regions. The subcells may be electrically connected in parallel or in series.

In some embodiments, the charge transfer layer or charge recombination layer may be chosen from Al, Ag, Au, MoO$_3$, Li, LiF, Sn, Ti, WO$_3$, indium tin oxide (ITO), tin oxide (TO), gallium indium tin oxide (GITO), zinc oxide (ZO), or zinc indium tin oxide (ZITO). In another embodiment, the charge transfer layer or charge recombination layer may be comprised of metal nanoclusters, nanoparticles, or nanorods.

The devices of the present disclosure may be, for example, photodetectors, photoconductors, or organic PV devices, such as solar cells.

Methods of preparing organic photosensitive optoelectronic devices of the present disclosure are also disclosed herein. In one embodiment, a method of fabricating an organic photosensitive optoelectronic device comprises depositing a photoactive region over a first electrode, and depositing a second electrode over the photoactive region, wherein the photoactive region comprises a donor mixture and an organic acceptor material, the donor mixture comprising at least one organic polymer donor material and at least one squaraine donor.

In some embodiments, depositing a photoactive region over a first electrode comprises co-depositing the at least one organic polymer donor material and the at least one squaraine donor over the first electrode, and depositing the organic acceptor material over the first electrode, wherein the co-deposition of the at least one organic polymer donor material and the at least one squaraine donor occurs before or after the deposition of the organic acceptor material over the first electrode. In some embodiments, the first electrode is optimized to receive and transport holes, and the at least one organic polymer donor material and the at least one squaraine donor is co-deposited over the first electrode before the deposition of the organic acceptor material over the first electrode. In other embodiments, the first electrode is optimized to receive and transport electrons, and the organic acceptor material is deposited over the first electrode before the co-deposition of the at least one organic polymer donor material and the at least one squaraine donor over the first electrode. The at least one organic polymer donor material and the at least one squaraine donor may be co-deposited at a polymer donor: squaraine ratio ranging from 1:0.005 to 1:0.2 by weight. In some embodiments, the polymer donor: squaraine ratio ranges from 1:0.01 to 1:0.1 by weight. In certain embodiments, the polymer donor: squaraine ratio is 1:0.05 by weight.

In another embodiment, depositing a photoactive region over a first electrode comprises co-depositing the at least one organic polymer donor material, the at least one squaraine donor, and the organic acceptor material over the first electrode. In some embodiments, the co-deposition is at a polymer donor: acceptor: squaraine ratio ranging from 1:0.5:x to 1:1.5:x by weight, wherein x represents a number ranging from 0.005 to 0.2. In some embodiments, x represents a number ranging 0.01 to 0.1.

As described herein, additional layers, such as transport layers, blocking layers, smoothing layers, and other buffer layers known in the art for organic photosensitive optoelectronic devices may be deposited during fabrication of the devices.

Layers and materials may be deposited using techniques known in the art. For example, the layers and materials described herein can be deposited from a solution, vapor, or a combination of both. In some embodiments, the organic materials or organic layers can be deposited or co-deposited via solution processing, such as by one or more techniques chosen from spin-coating, spin-casting, spray coating, dip coating, doctor-blading, inkjet printing, or transfer printing.

In other embodiments, the organic materials may be deposited or co-deposited using vacuum evaporation, such as vacuum thermal evaporation, organic vapor phase deposition, or organic vapor-jet printing.

It should be understood that embodiments described herein may be used in connection with a wide variety of other structures. Functional organic optoelectronic devices may be achieved by combining the various layers described in different ways, or layers may be omitted entirely, based on design, performance, and cost factors. Additional layers not specifically described may also be included. Materials other than those specifically described may be used. The names given to the various layers herein are not intended to be strictly limiting.

Other than in the examples, or where otherwise indicated, all numbers expressing quantities of ingredients, reaction conditions, analytical measurements and so forth, used in the specification and claims are to be understood as being modified in all instances by the term "about." Accordingly, unless indicated to the contrary, the numerical parameters set forth in the specification and attached claims are approximations that may vary depending upon the desired properties sought to be obtained by the present disclosure. At the very least, and not as an attempt to limit the application of the doctrine of equivalents to the scope of the claims, each numerical parameter should be construed in light of the number of significant digits and ordinary rounding approaches.

Notwithstanding that the numerical ranges and parameters setting forth the broad scope of the disclosure are approximations, unless otherwise indicated the numerical values set forth in the specific examples are reported as precisely as possible. Any numerical value, however, inherently contains certain errors necessarily resulting from the standard deviation found in their respective testing measurements.

The devices and methods described herein will be further described by the following non-limiting examples, which are intended to be purely exemplary.

## Examples

Organic photosensitive optoelectronic devices were fabricated using a 2,4-bis[4-(N,N-diisobutylamino)-2,6-dihydroxyphenyl] squaraine (DBSQ) additive and a poly(3-hexylthiophene) (P3HT) polymer donor material. DBSQ strongly absorbs from a wavelength of $\lambda$ = 520 to 750 nm with a peak optical density of $2.0 \times 10^5$ cm$^{-1}$ at $\lambda$ = 700 nm, whereas P3HT absorbs from $\lambda$ = 400 to 630 nm. Fabricated devices had the following structure: indium tin oxide (ITO, 50 nm)/poly-(3,4-ethylenedioxythiophene):polystyrenesulfonate (PEDOT:PSS, 40 nm)/P3HT: [6,6]-phenyl C61-butyric acid methyl ester (PCBM): DBSQ (140nm)/LiF 1 nm)/Al (200 nm). The DBSQ concentrations in the photoactive region were varied at 0, 5 wt% and 10 wt%. The relative ratio of P3HT:PCBM was 1:0.7. The P3HT:PCBM:DBSQ blend was dissolved in chlorobenzene at a concentration of 4.0 wt%, and then was spin-coated to a thickness of 140 nm onto the ITO layer with a sheet resistivity of 10 $\Omega$/square. Following spin coating, the P3HT:PCBM:DBSQ layer was baked at 120 °C for 10 minutes inside of a glove box filled with ultrahigh purity $N_2$ gas.

The absorption spectrum of the P3HT:PCBM:DBSQ blended film spin-coated on a quartz substrate was measured using an ultraviolet-visible (UV-Vis) spectrophotometer (Shimadzu, UV-2501 PC). The photoluminescence spectrum was recorded using a fluorescence spectrophotometer (Hitachi, F-7000). Organic PV device performance was measured using an Abet solar simulator with a Keithley 2400 source measurement unit under 1 sun (100 mW/cm$^2$) illumination intensity, after spectral mismatch correction. The morphology of the P3HT:PCBM:DBSQ film was analyzed using atomic force microscopy (AFM; Digital Instrumet Co. Multimode Nanoscope IIIa) in the tapping mode with a Si tip. X-ray diffraction spectra of P3HT:PCBM:DBSQ films spin coated on PEDOT:PSS/ITO coated glass substrate were obtained using a Rigaku Ultima IV and a Cu K$\alpha$ radiation source.

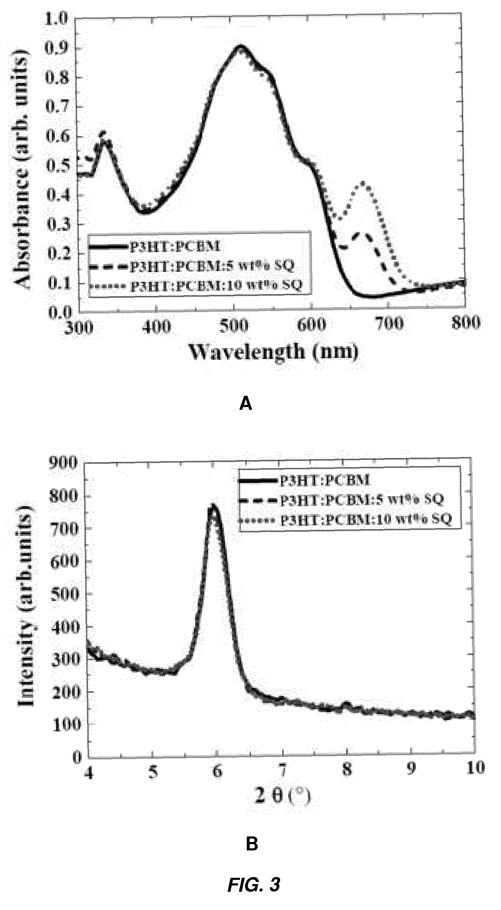

The UV-Vis absorption spectrum of the P3HT:PCBM:DBSQ blended film was measured as a function of DBSQ concentration, with results shown in Fig. 3A. As the solubility of DBSQ is < 4 wt % in chlorobenzene, the DBSQ concentration was kept at $\leq$ 10 wt% in the P3HT:PCBM:DBSQ blends. The blend is transparent at wavelengths $\lambda$ > 650 nm, i.e., the blend transmits $\geq$ 50% of incident radiation at wavelengths $\lambda$ > 650 nm, while absorption between $\lambda$ = 650 and 750 nm increases with DBSQ concentration. For example, the peak absorption of DBSQ at $\lambda$ = 680 nm is 40% that of P3HT for a DBSQ concentration of only 10 wt%.

X-ray diffraction of a spin-coated P3HT:PCBM:DBSQ blend was used to study the effect of DPSQ on film morphology. Figure 3B shows an X-ray diffraction pattern of P3HT:PCBM:DBSQ films after thermal annealing at 120 °C under N$_2$ atmosphere for 10 minutes. The blended film exhibited a peak at angle 2$\theta$ = 6.0° assigned to diffraction from the (100) crystal plane of P3HT. The peak expected for DBSQ at 2$\theta$ = 8.0° was notably absent. The intensity of the P3HT diffraction peak remained unchanged for the 5 wt% and 10 wt% DBSQ mixed films, indicating that DBSQ does not hinder the crystallization of P3HT.

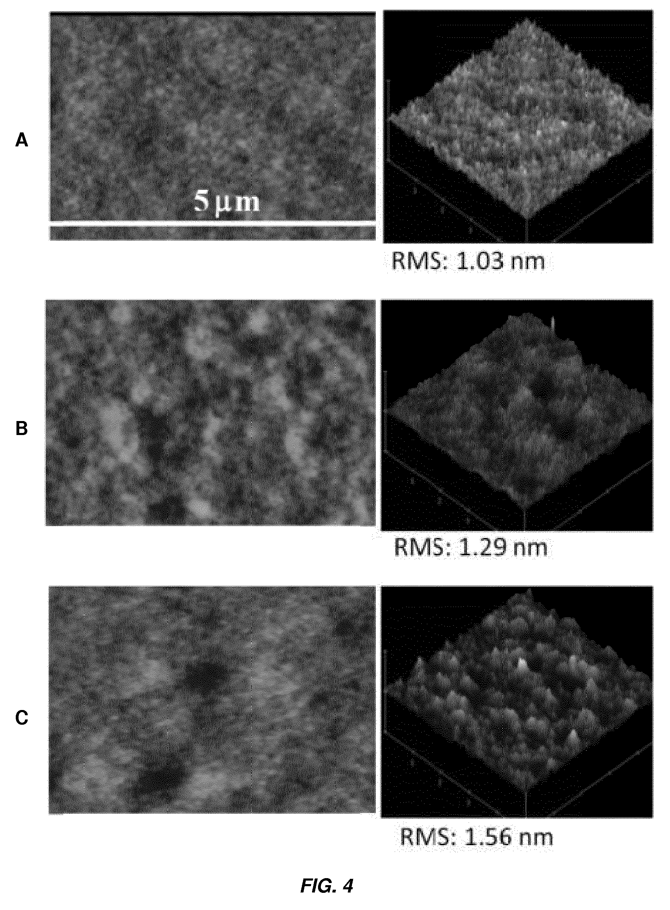

Fig. 4 shows atomic force microscope (AFM) images of a series of P3HT:PCBM:DBQ films with different concentrations of DBSQ. The neat P3HT:PCBM film exhibited a smooth surface morphology with a root mean square roughness of RMS = 1.1 $\pm$ 0.1 nm. The smooth surface morphology of the blend film was roughened by adding DBSQ. For example, the roughness of the film consisting of 10 wt% DBSQ in P3HT:PCBM was RMS = 1.6 $\pm$ 0.2 nm. Evidence of phase separation in the 10 wt% DBSQ film was also observed, possibly due to precipitation of DBSQ.

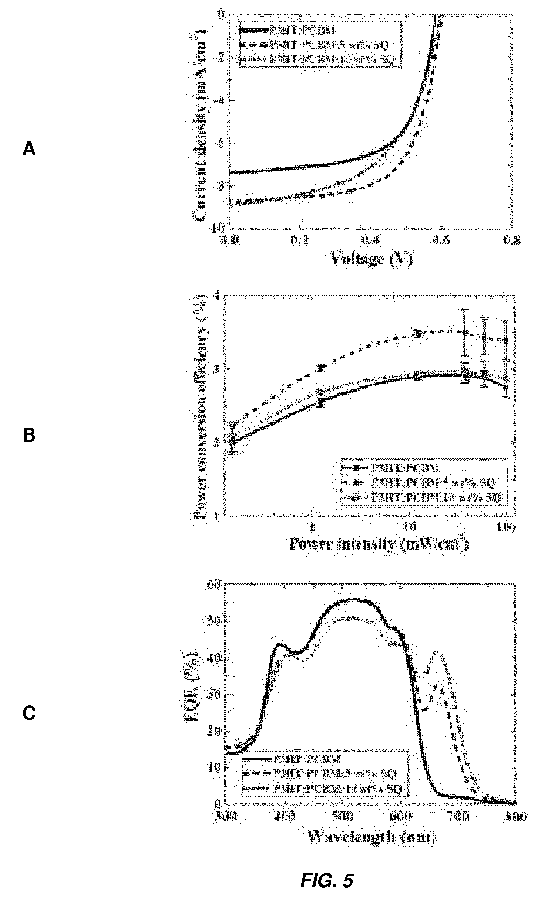

Fig. 5A shows current density-voltage (J-V) characteristics of P3HT:PCBM:DBSQ devices with varying DBSQ concentrations. $J_{SC}$ increased from 7.3 $\pm$ 0.3 mA/cm$^2$ to 8.9 $\pm$ 0.1 mA/cm$^2$ under 1 sun, AM1.5G illumination by adding DBSQ due to the expended UV-Vis absorption spectral range of the P3HT:PCBM:DBSQ photoactive region. There was a sharp increase to $J_{SC}$ = 8.8 $\pm$ 0.1 mA/cm$^2$ by adding only 5 wt% of DBSQ, whereas a further increase of DBSQ content did not significantly increase $J_{SC}$. In contrast, $V_{OC}$ was not affected by adding DBSQ, leading to only a 0.02 V increase since the highest occupied molecular orbital (HOMO) energy of DBSQ at -5.3 eV is comparable to -5.1 eV for P3HT. The larger HOMO energy of DBSQ contributed to the slight increase observed for $V_{OC}$.

The fill factor (FF) of 0.64 $\pm$ 0.01 of the P3HT:PCBM device remained constant up to 5 wt% DBSQ concentration, and then decreased to FF = 0.53 $\pm$ 0.04 at 10 wt% DBSQ. As shown in the AFM images of P3HT:PCBM:DBSQ films spin-coated on PEDOT:PSS (Fig. 4), large-scale phase separation was observed at 10 wt% DBSQ. This led to an increased series resistance of the device, and hence a concomitant decrease in FF. The specific series resistance of the P3HT:PCBM:DBSQ device calculated from dark J-V characteristics using the modified ideal diode equation was increased from 3.2 $\pm$ 0.2 $\Omega\cdot$cm2 for neat P3HT:PCBM films to 11 $\pm$ 3 $\Omega\cdot$cm$^2$ at 10 wt% DBSQ.

The power conversion efficiency (PCE) of P3HT:PCBM:DBSQ organic PVs was measured as a function of the power intensity of AM1.5G simulated illumination, and the results are shown in Fig. 5B. The PCE of the P3HT:PCBM device was 2.8 $\pm$ 0.1% at 1 sun (100 mW/cm$^2$) intensity, which increased to 3.4 $\pm$ 0.3% by with the addition of 5 wt% DBSQ. The 20% increase in PCE obtained by the addition of DBSQ was primarily due to increased absorption at long wavelength in the blended film (See Fig. 3A). The expanded absorption spectral range of P3HT:PCBM:DBSQ resulted in an increase in $J_{SC}$. However, upon increasing the DBSQ concentration to 10 wt%, only a marginal further increase in PCE was observed compared to the P3HT:PCBM device due to the reduced FF, as discussed above.

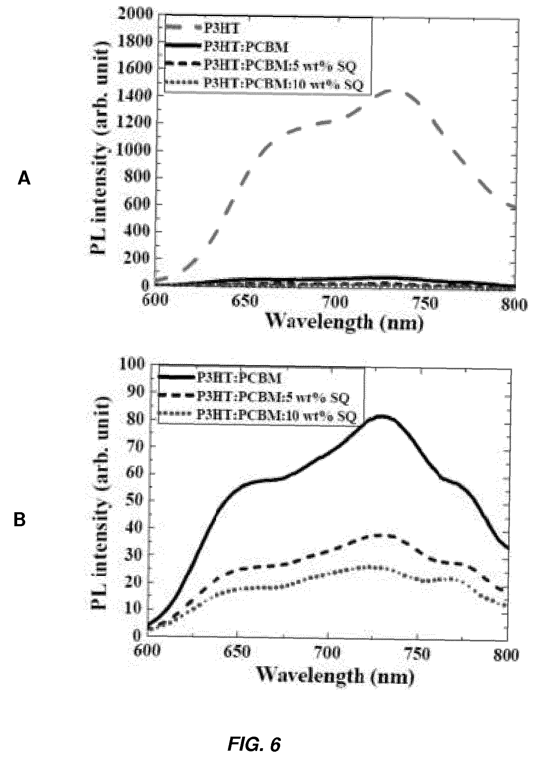

The external quantum efficiency (EQE) of P3HT:PCBM:5 wt% DBSQ at wavelengths $\lambda$ > 650 nm shown in Fig. 5C was increased compared to that of a neat P3HT:PCBM bulk heterojunction cell due to the additional NIR absorption of the DBSQ blend. However, the EQE in the visible range due to P3HT:PCBM absorption was reduced with the addition of 10 wt% DBSQ. This is due to differences in the charge generation mechanisms in the presence of DBSQ. There are at least three possible routes to charge generation: (i) Exciton dissociation at P3HT:PCBM domain interfaces, (ii) exciton dissociation at DBSQ:PCBM interfaces, and (iii) hole and electron generation by energy transfer from P3HT to DBSQ. In this latter process, excitons generated on P3HT transfer energy via a Förster process to DBSQ before diffusion to an interface with PCBM. This route is energetically allowed since the photoluminescence (PL) emission of P3HT is between $\lambda$ = 600 and 850 nm, which overlaps the peak absorption of DBSQ at $\lambda$ = 700 nm. The DBSQ excitons then dissociate into holes and electrons at the interface with PCBM. The energy transfer from P3HT to DBSQ was confirmed by PL measurements of P3HT:PCBM:DBSQ, with spectra shown in Fig. 6.

Emission from P3HT is primarily quenched by PCBM, and the P3HT emission from the P3HT:PCBM mixture was further quenched by adding DBSQ, which confirms the existence of energy transfer from P3HT to DBSQ. The relative P3HT intensity of the P3HT:PCBM:5 wt% DBSQ was only 45% of P3HT emission of P3HT:PCBM, indicating that 5 wt% DBSQ can quench 55% of excitons generated in P3HT. For P3HT:PCBM:10 wt% DBSQ, approximately 70% of the P3HT excited states were quenched by energy transfer to DBSQ. It may be inferred from these results that 95% of the excitons generated in P3HT are dissociated at interfaces with PCBM (route (i)), and 3.0% and 3.8% of P3HT excitons are transferred to DBSQ for concentrations of 5 wt% and 10 wt%, respectively (route (iii)).

In addition, the EQE of the P3HT:PCBM:5 wt% DBSQ device was high relative to the absorption of P3HT:PCBM:5 wt% DBSQ. This indicates that excitons generated on DBSQ were efficiently dissociated. Hence, at this concentration, it is likely that DBSQ molecules were located close (within a Förster radius) to the PCBM. The short exciton diffusion length of DBSQ (< 2 nm) and high EQE of DBSQ provide further evidence that DBSQ molecules were within close proximity to PCBM.

Device performance is summarized in Table 1 below.

Table 1. Device performance of P3HT:PCBM:DBSQ bulk heterojunctionsolar cells

|  | $J_{sc}$ (111,k/cn$^y$) | $V_{oc}$ (V) | FF (%) | PCE (%) | $R_sA$ ($\Omega \cdot cm^2$) |
|---|---|---|---|---|---|
| P3HT:PCBM | 7.3±0.3 | 0.59±0.01 | 64±0.1 | 2.75±0.13 | 3.2±0.2 |
| P3HT:PCBM: 5wt% DPSQ | 8.8±0.1 | 0.61±0.01 | 64±4 | 3.38±0.27 | 6.6±0.4 |
| P3HT:PCBM:10wt% DPSQ | 8.9±0.1 | 0,61±0,01 | 53±4 | 2.88±0,25 | 11.4±2.6 |

In sum, the PCEs of P3HT:PCBM organic PVs were increased by greater than 20% through the addition of a small concentration of DBSQ into the mixture, thereby enhancing the NIR absorption of the resulting PV. A power conversion efficiency of 3.4 ± 0.3% and an external quantum efficiency as high as 55% was achieved for a P3HT:PCBM blend that included 5 wt% DBSQ.

**Claims**

1. An organic photosensitive optoelectronic device comprising:

   two electrodes in superposed relation;
   a photoactive region located between the two electrodes, wherein the photoactive region comprises a donor mixture and an organic acceptor material, the donor mixture comprising at least one organic polymer donor material and at least one squaraine donor.

2. The device of claim 1, wherein the at least one squaraine donor has a maximum absorptivity at a longer wavelength than a maximum absorptivity of the at least one organic polymer donor material.

3. The device of claim 1, wherein the at least one squaraine donor has an absorptivity of at least $10^3$ cm$^{-1}$ at one or more wavelengths ranging from 450 to 950 nm.

4. The device of claim 1, wherein the at least one squaraine donor has an absorptivity of at least $10^5$ cm$^{-1}$ at one or more wavelengths ranging from 450 to 950 nm.

5. The device of claim 1, wherein the donor mixture comprises the at least one organic polymer donor material and the at least one squaraine donor at a polymer donor: squaraine ratio ranging from 1:0.005 to 1:0.2 by weight.

6. The device of claim 5, wherein the polymer donor: squaraine ratio ranges from 1:0.01 to 1:0.1 by weight.

7. The device of claim 1, wherein the donor mixture and the organic acceptor material form a donor-acceptor heterojunction.

8. The device of claim 7, wherein the donor-acceptor heterojunction is chosen from a mixed heterojunction, a bulk heterojunction, a planar heterojunction, and a hybrid planar-mixed heterojunction.

9. The device of claim 1, wherein the at least one squaraine donor is chosen from 2,4-bis[4-(N,N-diisobutylamino)-2,6-dihydroxyphenyl] (DBSQ), 2,4-bis[4-N-carbazolo-2,6-dihydroxyphenyl] squaraine (CBZSQ), 2,4-bis[4-N-phenothiazino-2,6-dihydroxyphenyl] squaraine (PTSQ), 2,4-bis[4-(N,N-diphenylamino)-2,6-dihydroxyphenyl] squaraine (DPSQ), 2,4-bis[4-(N-Phenyl-1-naphthylamino)-2,6-dihydroxyphenyl] squaraine (1 NPSQ), 2,4-bis[4-(N-Phenyl-2-naphthylamino)-2,6-dihydroxyphenyl] squaraine (2NPSQ), {2-[4-(N,N-diisobutylamino)-2,6-dihydroxyphenyl]-4-diphenylamino} squaraine (USSQ), {2-[4-(N,N-diphenylamino)-2,6-dihydroxyphenyl]-4-diphenylamino} squaraine (DPUSQ), and diphenylamino-squarate (YSQ).

10. The device of claim 1, wherein the at least one organic polymer donor material is chosen from polythiophene, polycarbazole, polyfluorene, polydithienosilole, polybenzodithiophene, and copolymers thereof.

11. The device of claim 1, wherein the at least one organic polymer donor material is chosen from poly[2-methoxy-5-(2'-ethylhexyloxy)-p-phenylene vinylene], poly(3-hexylthiophene) (P3HT), poly[2,6-(4,4-bis-(2-ethylhexyl)-4H-cyclopenta[2,1-b;3,4-b']dithiophene-alt-4,7-(2,1,3-benzothiadiazole)], poly[N-9"-hepta-decanyl-2,7-carbazole-alt-5,5-(4',7'-di-2-thienyl-2',1',3'-benzothiadiazole)], poly(4,4-dioctyldithieno(3,2-b:2',3'-d)silole)-2,6-diyl-alt-(2,1,3-benzothiadiazole)-4,7-diyl), poly{2,6-4,8-di(5-ethylhexylthienyl)benzo[1,2-b;3,4-b]dithiophene-alt-5-dibutyloctyl-3,6-bis(5-bromothiophen-2-yl)pyrrolo[3,4-c]pyrrole-1,4-dione}, poly[2,7-(9,9-didecylfluorene)-alt-5,5-(4,7-di-2-thienyl-2,1,3-benzothiadiazole)], and alternating copolymer of thieno[3,4-b]-thiophene and benzodithiophene.

12. The device of claim 1, wherein the organic acceptor material comprises at least one compound chosen from perylenes, naphthalenes, fullerenes, and derivatives thereof.

13. The device of claim 1, wherein the at least one organic polymer donor material is P3HT and the organic acceptor material comprises a fullerene or a derivative thereof.

14. A method of fabricating an organic photosensitive optoelectronic device comprising:

depositing a photoactive region over a first electrode; and
depositing a second electrode over the photoactive region, wherein the photoactive region comprises a donor mixture and an organic acceptor material, the donor mixture comprising at least one organic polymer donor material and at least one squaraine donor.

15. The method of claim 14, wherein the deposition of a photoactive region over a first electrode comprises co-depositing the at least one organic polymer donor material and the at least one squaraine donor over the first electrode, and depositing the organic acceptor material over the first electrode, wherein the co-deposition of the at least one organic polymer donor material and the at least one squaraine donor occurs before or after the deposition of the organic acceptor material over the first electrode.

16. The method of claim 15, wherein the at least one organic polymer donor material and the at least one squaraine donor are co-deposited at a polymer donor:

squaraine ratio ranging from 1:0.005 to 1:0.2 by weight.

17. The method of claim 14, wherein the deposition of a photoactive region over a first electrode comprises co-depositing the at least one organic polymer donor material, the at least one squaraine donor, and the organic acceptor material over the first electrode.

18. The method of claim 17, wherein the at least one organic polymer donor material, the organic acceptor material, and the at least one squaraine donor are co-deposited at a polymer donor: acceptor: squaraine ratio ranging from 1:0.5:x to 1:1.5:x by weight, wherein x represents a number ranging from 0.005 to 0.2.

**FIG. 1**

**FIG. 2**

**A**

**B**

*FIG. 3*

**FIG. 4**

A

B

C

*FIG. 5*

*FIG. 6*

Europäisches
Patentamt

European
Patent Office

Office européen
des brevets

# EUROPEAN SEARCH REPORT

Application Number

EP 16 18 0086

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SHYAM S. PANDEY ET AL: "Solution processable thin film organic photovoltaic cells based on far red sensitive soluble squaraine dyes", THIN SOLID FILMS, vol. 522, 30 August 2012 (2012-08-30), pages 401-406, XP055125204, ISSN: 0040-6090, DOI: 10.1016/j.tsf.2012.08.043 * page 401, column 2, line 25 - page 402, column 2, line 57; figures 1-3 * | 1-18 | INV. H01L51/46 ADD. H01L51/00 |
| A | US 2012/181527 A1 (SRAMEK MARIA [DE] ET AL) 19 July 2012 (2012-07-19) * the whole document * | 1-18 | |
| A | XIN XIAO ET AL: "Small-Molecule Photovoltaics Based on Functionalized Squaraine Donor Blends", ADVANCED MATERIALS, vol. 24, no. 15, 26 March 2012 (2012-03-26), pages 1956-1960, XP055093454, ISSN: 0935-9648, DOI: 10.1002/adma.201104261 * the whole document * | 1-18 | |

TECHNICAL FIELDS
SEARCHED (IPC)

H01L

The present search report has been drawn up for all claims

| Place of search | Date of completion of the search | Examiner |
|---|---|---|
| The Hague | 17 October 2016 | Fratiloiu, Silvia |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 16 18 0086

This annex lists the patent family members relating to the patent documents cited in the above-mentioned European search report.
The members are as contained in the European Patent Office EDP file on
The European Patent Office is in no way liable for these particulars which are merely given for the purpose of information.

17-10-2016

| Patent document cited in search report | Publication date | Patent family member(s) | Publication date |
|---|---|---|---|
| US 2012181527 A1 | 19-07-2012 | DE 102009043348 A1<br>EP 2486608 A1<br>JP 5487312 B2<br>JP 2013506282 A<br>KR 20120091020 A<br>US 2012181527 A1<br>WO 2011039182 A1 | 07-04-2011<br>15-08-2012<br>07-05-2014<br>21-02-2013<br>17-08-2012<br>19-07-2012<br>07-04-2011 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 61712783 A
- US 61717073 A
- US 61766098 A
- US 6352777 B
- US 20120248419 A

- US 20100102304 A
- US 20120235125 A
- US 20110012091 A
- US 7230269 B
- US 6451415 B